(19) Europäisches Patentamt
European Patent Office
Office européen des brevets

(11) EP 0 698 587 B1

(12) **EUROPEAN PATENT SPECIFICATION**

(45) Date of publication and mention
of the grant of the patent:
**12.11.1997 Bulletin 1997/46**

(51) Int Cl.6: **C04B 35/493**, H01L 41/187

(21) Application number: **95111696.1**

(22) Date of filing: **25.07.1995**

(54) **Piezoelectric porcelain**

Piezoelektrisches Porzellan

Porcelaine piézoélectrique

(84) Designated Contracting States:
**DE IT NL**

(30) Priority: **27.07.1994 JP 175541/94**

(43) Date of publication of application:
**28.02.1996 Bulletin 1996/09**

(73) Proprietor: **MURATA MANUFACTURING CO., LTD.**
**Nagaokakyo-shi Kyoto-fu 226 (JP)**

(72) Inventors:
• **Kimura, Masanori**
**Nagaokakyo-shi, Kyoto-fu (JP)**
• **Sube, Mitsuru**
**Shiga (JP)**

(74) Representative:
**Herrmann-Trentepohl, Werner, Dipl.-Ing.**
**Patentanwälte**
**Herrmann-Trentepohl**
**Grosse - Bockhorni & Partner**
**Forstenrieder Allee 59**
**81476 München (DE)**

(56) References cited:
**EP-A- 0 260 875          FR-A- 2 252 311**
**FR-A- 2 332 962**

• **JAP. J. APPL. PHYS., vol. 9, no. 10, October 1970
pages 1236-1246, M. TAKAHASHI 'space charge
effect in lead zirconate titanate ceramics caused
by the addition of impurities'**
• **JOURNAL OF THE AMERICAN CERAMIC
SOCIETY, vol. 49, no. 11, 21 November 1966
pages 577-582, H. OUCHI ET AL. 'PIEZOLECTRIC
PROPERTIES...'**

**Description**

BACKGROUND OF THE INVENTION

Field of the Invention

The present invention relates to piezoelectric porcelain which is applied to a piezoelectric element such as a ceramic filter, a speaker, a microphone, a buzzer or a sensor.

Description of the Background Art

In general, piezoelectric porcelain which is applied to a ceramic filter or the like is mainly composed of lead titanate zirconate $(Pb(Ti_xZr_{1-x})O_3)$. Slight amounts of various additives are added to such piezoelectric porcelain, in order to improve its piezoelectricity.

A piezoelectric material which is basically composed of $Pb(Mg_{1/3}Nb_{2/3})O_3$-$PbTiO_3$-$PbZrO_3$, known as one of lead titanate zirconate materials, is generally prepared by mixing oxide raw materials such as lead oxide, zirconium oxide, titanium oxide, magnesium oxide and niobium pentoxide with each other to attain a prescribed stoichiometric composition, mixing and dispersing the same in a ball mill or the like, thereafter calcining the mixture at a prescribed temperature, crushing the mixture and mixing the same with a binder, molding the mixture into a prescribed shape, firing the same at a high temperature of at least 1200°C to make sintering reaction, and polarizing the sintered body.

When such piezoelectric porcelain is applied to an electromechanical transducer element such as a speaker or a microphone requiring a high output voltage and a flat frequency response, it is desirable that the material itself has a large electromechanical coupling factor and a high dielectric constant, in order to increase the electrostatic capacitance of the element.

Japanese Patent Publication No. 44-17103 (1969) describes $Pb(Mg_{1/3}Nb_{2/3})O_3$-$PbTiO_3$-$PbZrO_3$ porcelain as piezoelectric porcelain which attains the aforementioned object. However, the electromechanical coupling factor of the piezoelectric porcelain described in this gazette is too small to completely solve the problem.

When the width between attenuation poles depends on the electromechanical coupling factor in a filter which is prepared from piezoelectric porcelain for serving as an electromechanical transducer element, the material desirably has a large electromechanical coupling factor and a small mechanical quality factor. However, the piezoelectric porcelain described in Japanese Patent Publication No. 44-17103 is insufficient in electromechanical coupling factor and mechanical quality factor.

US-A-39 56 150 discloses piezoelectric porcelain compositions of the general formula $Pb([B]_ANb_{1-A})O_3$-$PbTiO_3$-$PbZrO_3$, where B is selected from a group of metals which does not include chromium.

SUMMARY OF THE INVENTION

An object of the present invention is to provide piezoelectric porcelain having a large electromechanical coupling factor, a small mechanical quality factor and a high dielectric constant, which can broaden the band of a filter and is applicable to a speaker, a microphone, a buzzer or a sensor.

The piezoelectric porcelain according to the present invention is a lead-containing composite oxide which is expressed in a general formula $aPb_x(Cr_yNb_{1-x})O_3$-$bPb_xTiO_3$-$cPb_xZrO_3$, with a, b and c being in the following ranges respectively:

$$1.0 \leq a \leq 12.0$$

$$40.5 \leq b \leq 49.0$$

$$39.0 \leq c \leq 58.5$$

where a, b and c are in units of mole % and $a + b + c = 100$, and x and y being in the following ranges respectively:

$$0.95 \leq x \leq 1.01$$

$$2/24 \leq y \leq 11/24$$

The value of the component a in $aPb_x(Cr_yNb_{1-y})O_3$ is selected from the range of $1.0 \leq a \leq 12.0$, preferably from the range of $2.0 \leq a \leq 10.0$, and more preferably from the range of $3.0 \leq a \leq 9.0$. If the value of a is too small or large, the electromechanical coupling factor and the dielectric constant are reduced and the mechanical quality factor is increased.

The value of the component b in $bPb_xTiO_3$ is selected from the range of $40.5 \leq b \leq 49.0$, preferably from the range of $43.0 \leq b \leq 48.0$, and more preferably from the range of $43.0 \leq b \leq 47.0$. If the value of b is too small or large, the electromechanical coupling factor and the dielectric constant are reduced.

The value of the component c in $cPb_xZrO_3$ is selected from the range of $39.0 \leq c \leq 58.5$, preferably from the range of $47.0 \leq c \leq 52.0$, and more preferably from the range of $48.0 \leq c \leq 52.0$. If the value of c is too small or large, the electromechanical coupling factor and the dielectric constant are reduced and the mechanical quality factor is increased.

The value x indicating the rate of the Pb component is selected from the range of $0.95 \leq x \leq 1.01$, preferably from the range of $0.96 \leq x \leq 1.00$. If the value of x is too small or large, the electromechanical coupling factor and the dielectric constant are reduced.

The value of y indicating the ratio of Cr to Nb is selected from the range of $2/24 \leq y \leq 11/24$, preferably from the range of $5/24 \leq y \leq 10.5/24$, and more preferably from the range of $6/24 \leq y \leq 10/24$. If the value of y is too small or large, the electromechanical coupling factor and the dielectric constant are reduced and the mechanical quality factor is increased.

In the piezoelectric porcelain according to the present invention, not more than 11 mole %, preferably not more than 5 mole %, of the Pb component can be substituted by at least one element of Sr, Ba and Ca. If the amount of the substituted Pb component is too large, the electromechanical coupling factor is reduced. It is possible to attain piezoelectric porcelain having a large electromechanical coupling factor, a small mechanical quality factor and a large dielectric constant by substituting the Pb component in the aforementioned range.

According to the present invention, it is possible to obtain piezoelectric porcelain having piezoelectricity with a large electromechanical coupling factor, a small mechanical quality factor and a large dielectric constant, thereby broadening the band. Thus, the piezoelectric porcelain according to the present invention can be applied to a speaker, a microphone, a buzzer or a sensor.

The foregoing and other objects, features, aspects and advantages of the present invention will become more apparent from the following detailed description of the present invention.

DESCRIPTION OF THE PREFERRED EMBODIMENTS

Lead oxide, zirconium oxide, titanium oxide, chromium oxide and niobium oxide were prepared as raw materials, and mixed with each other at composition ratios shown in Tables 1 to 3. The mixed raw materials were wet-blended in a ball mill, demineralized, dried, and calcined at 800 to 1000°C for 2 hours. The calcined powder materials were again wet-blended in a ball mill, thereby preparing powder materials.

Then, caking additives such as water or polyvinyl alcohol were added to the powder materials, which in turn were press-molded and thereafter fired at 1110 to 1320°C for 2 hours, thereby obtaining sintered bodies.

The obtained sintered bodies were polished into discs of 10 mm in diameter and 1 mm in thickness, and silver electrodes were baked on both end surfaces of the discs. These discs were polarized in insulating oil of 60 to 80°C for 10 to 60 minutes in electric fields of 2.5 to 4 kV/mm, to obtain piezoelectric porcelain samples.

Table 1

| Sample No. | $aPb_x(Cr_yNb_{1-y})O_3\text{-}bPb_xTiO_3\text{-}cPb_xZrO_3$ | | | | | | | |
|---|---|---|---|---|---|---|---|---|
| | a mol% | b mol% | c mol% | x | Substitutional Element for Pb (mol%) | | | y |
| | | | | | Sr | Ba | Ca | |
| 1* | 5.0 | 40.0* | 55.0 | 1.00 | 0.0 | 0.0 | 0.0 | 8/24 |
| 2 | 5.0 | 40.5 | 54.5 | 1.00 | 0.0 | 0.0 | 0.0 | 8/24 |
| 3 | 5.0 | 45.5 | 49.5 | 1.00 | 0.0 | 0.0 | 0.0 | 8/24 |
| 4 | 5.0 | 49.0 | 46.0 | 1.00 | 0.0 | 0.0 | 0.0 | 8/24 |
| 5* | 5.0 | 50.0* | 45.0 | 1.00 | 0.0 | 0.0 | 0.0 | 8/24 |
| 6* | 5.0 | 45.5 | 49.5 | 0.94* | 0.0 | 0.0 | 0.0 | 8/24 |

Table 1   (continued)

| Sample No. | $aPb_x(Cr_yNb_{1-y})O_3-bPb_xTiO_3-cPb_xZrO_3$ | | | | | | | |
|---|---|---|---|---|---|---|---|---|
| | a mol% | b mol% | c mol% | x | Substitutional Element for Pb (mol%) | | | y |
| | | | | | Sr | Ba | Ca | |
| 7 | 5.0 | 45.5 | 49.5 | 0.95 | 0.0 | 0.0 | 0.0 | 8/24 |
| 8 | 5.0 | 45.5 | 49.5 | 1.01 | 0.0 | 0.0 | 0.0 | 8/24 |
| 9* | 5.0 | 45.5 | 49.5 | 1.02* | 0.0 | 0.0 | 0.0 | 8/24 |
| 10* | 0.5* | 45.5 | 54.0 | 1.00 | 0.0 | 0.0 | 0.0 | 8/24 |
| 11 | 1.0 | 45.5 | 53.5 | 1.00 | 0.0 | 0.0 | 0.0 | 8/24 |
| 12 | 12.0 | 45.5 | 42.5 | 1.00 | 0.0 | 0.0 | 0.0 | 8/24 |
| 13* | 13.0* | 45.5 | 41.5 | 1.00 | 0.0 | 0.0 | 0.0 | 8/24 |
| 14* | 1.0 | 40.0* | 59.0* | 1.00 | 0.0 | 0.0 | 0.0 | 8/24 |
| 15* | 1.0 | 50.0* | 49.0 | 1.00 | 0.0 | 0.0 | 0.0 | 8/24 |
| 16* | 12.0 | 40.0* | 48.0 | 1.00 | 0.0 | 0.0 | 0.0 | 8/24 |
| 17* | 12.0 | 50.0* | 38.0* | 1.00 | 0.0 | 0.0 | 0.0 | 8/24 |
| 18* | 5.0 | 45.5 | 49.5 | 1.00 | 0.0 | 0.0 | 0.0 | 1/24* |
| 19 | 5.0 | 45.5 | 49.5 | 1.00 | 0.0 | 0.0 | 0.0 | 2/24 |
| 20 | 5.0 | 45.5 | 49.5 | 1.00 | 0.0 | 0.0 | 0.0 | 8/24 |
| 21 | 5.0 | 45.5 | 49.5 | 1.00 | 0.0 | 0.0 | 0.0 | 11/24 |
| 22* | 5.0 | 45.5 | 49.5 | 1.00 | 0.0 | 0.0 | 0.0 | 12/24* |

Table 2

| Sample No. | $aPb_x(Cr_yNb_{1-y})O_3-bPb_xTiO_3-cPb_xZrO_3$ | | | | | | | |
|---|---|---|---|---|---|---|---|---|
| | a mol% | b mol% | c mol% | x | Substitutional Element for Pb (mol%) | | | y |
| | | | | | Sr | Ba | Ca | |
| 23* | 5.0 | 40.0* | 55.0 | 0.99 | 2.0 | 0.0 | 0.0 | 8/24 |
| 24 | 5.0 | 40.5 | 54.5 | 0.99 | 2.0 | 0.0 | 0.0 | 8/24 |
| 25 | 5.0 | 43.5 | 51.5 | 0.99 | 2.0 | 0.0 | 0.0 | 8/24 |
| 26 | 5.0 | 44.5 | 50.5 | 0.99 | 2.0 | 0.0 | 0.0 | 8/24 |
| 27 | 5.0 | 46.5 | 48.5 | 0.99 | 2.0 | 0.0 | 0.0 | 8/24 |
| 28 | 5.0 | 47.5 | 47.5 | 0.99 | 2.0 | 0.0 | 0.0 | 8/24 |
| 29 | 5.0 | 49.0 | 46.0 | 0.99 | 2.0 | 0.0 | 0.0 | 8/24 |
| 30* | 5.0 | 50.0* | 45.0 | 0.99 | 2.0 | 0.0 | 0.0 | 8/24 |
| 31* | 5.0 | 45.5 | 49.5 | 0.94* | 2.0 | 0.0 | 0.0 | 8/24 |
| 32 | 5.0 | 45.5 | 49.5 | 0.95 | 2.0 | 0.0 | 0.0 | 8/24 |
| 33 | 5.0 | 45.5 | 49.5 | 0.96 | 2.0 | 0.0 | 0.0 | 8/24 |
| 34 | 5.0 | 45.5 | 49.5 | 0.98 | 2.0 | 0.0 | 0.0 | 8/24 |
| 35 | 5.0 | 45.5 | 49.5 | 1.00 | 2.0 | 0.0 | 0.0 | 8/24 |
| 36 | 5.0 | 45.5 | 49.5 | 1.01 | 2.0 | 0.0 | 0.0 | 8/24 |
| 37* | 5.0 | 45.5 | 49.5 | 1.02* | 2.0 | 0.0 | 0.0 | 8/24 |
| 38* | 0.5* | 45.5 | 54.0 | 0.99 | 2.0 | 0.0 | 0.0 | 8/24 |
| 39 | 1.0 | 45.5 | 53.5 | 0.99 | 2.0 | 0.0 | 0.0 | 8/24 |
| 40 | 3.0 | 45.5 | 51.5 | 0.99 | 2.0 | 0.0 | 0.0 | 8/24 |
| 41 | 7.0 | 45.5 | 47.5 | 0.99 | 2.0 | 0.0 | 0.0 | 8/24 |
| 42 | 9.0 | 45.5 | 45.5 | 0.99 | 2.0 | 0.0 | 0.0 | 8/24 |
| 43 | 12.0 | 45.5 | 42.5 | 0.99 | 2.0 | 0.0 | 0.0 | 8/24 |
| 44* | 13.0* | 45.5 | 41.5 | 0.99 | 2.0 | 0.0 | 0.0 | 8/24 |
| 45* | 1.0 | 40.0* | 59.0* | 0.99 | 2.0 | 0.0 | 0.0 | 8/24 |
| 46* | 1.0 | 50.0* | 49.0 | 0.99 | 2.0 | 0.0 | 0.0 | 8/24 |

Table 2   (continued)

| Sample No. | aPb$_x$(Cr$_y$Nb$_{1-y}$)O$_3$-bPb$_x$TiO$_3$-cPb$_x$ZrO$_3$ | | | | | | | |
|---|---|---|---|---|---|---|---|---|
| | a mol% | b mol% | c mol% | x | Substitutional Element for Pb (mol%) | | | y |
| | | | | | Sr | Ba | Ca | |
| 47* | 12.0 | 40.0* | 48.0 | 0.99 | 2.0 | 0.0 | 0.0 | 8/24 |
| 48* | 12.0 | 50.0* | 38.0* | 0.99 | 2.0 | 0.0 | 0.0 | 8/24 |
| 49* | 5.0 | 45.5 | 49.5 | 0.99 | 2.0 | 0.0 | 0.0 | 1/24* |
| 50 | 5.0 | 45.5 | 49.5 | 0.99 | 2.0 | 0.0 | 0.0 | 2/24 |
| 51 | 5.0 | 45.5 | 49.5 | 0.99 | 2.0 | 0.0 | 0.0 | 4/24 |
| 52 | 5.0 | 45.5 | 49.5 | 0.99 | 2.0 | 0.0 | 0.0 | 6/24 |
| 53 | 5.0 | 45.5 | 49.5 | 0.99 | 2.0 | 0.0 | 0.0 | 8/24 |
| 54 | 5.0 | 45.5 | 49.5 | 0.99 | 2.0 | 0.0 | 0.0 | 10/24 |
| 55 | 5.0 | 45.5 | 49.5 | 0.99 | 2.0 | 0.0 | 0.0 | 11/24 |
| 56* | 5.0 | 45.5 | 49.5 | 0.99 | 2.0 | 0.0 | 0.0 | 12/24* |

Table 3

| Sample No. | aPb$_x$(Cr$_y$Nb$_{1-y}$)O$_3$-bPb$_x$TiO$_3$-cPb$_x$ZrO$_3$ | | | | | | | |
|---|---|---|---|---|---|---|---|---|
| | a mol% | b mol% | c mol% | x | Substitutional Element for Pb (mol%) | | | y |
| | | | | | Sr | Ba | Ca | |
| 57 | 5.0 | 45.5 | 49.5 | 0.99 | 4.0 | 0.0 | 0.0 | 8/24 |
| 58 | 5.0 | 45.5 | 49.5 | 0.99 | 6.0 | 0.0 | 0.0 | 8/24 |
| 59 | 5.0 | 45.5 | 49.5 | 0.99 | 8.0 | 0.0 | 0.0 | 8/24 |
| 60 | 5.0 | 45.5 | 49.5 | 0.99 | 11.0 | 0.0 | 0.0 | 8/24 |
| 61* | 5.0 | 45.5 | 49.5 | 0.99 | 12.0* | 0.0 | 0.0 | 8/24 |
| 62 | 5.0 | 45.5 | 49.5 | 0.99 | 0.0 | 2.0 | 0.0 | 8/24 |
| 63 | 5.0 | 45.5 | 49.5 | 0.99 | 0.0 | 6.0 | 0.0 | 8/24 |
| 64 | 5.0 | 45.5 | 49.5 | 0.99 | 0.0 | 11.0 | 0.0 | 8/24 |
| 65* | 5.0 | 45.5 | 49.5 | 0.99 | 0.0 | 12.0* | 0.0 | 8/24 |
| 66 | 5.0 | 45.5 | 49.5 | 0.99 | 0.0 | 0.0 | 2.0 | 8/24 |
| 67 | 5.0 | 45.5 | 49.5 | 0.99 | 0.0 | 0.0 | 6.0 | 8/24 |
| 68 | 5.0 | 45.5 | 49.5 | 0.99 | 0.0 | 0.0 | 11.0 | 8/24 |
| 69* | 5.0 | 45.5 | 49.5 | 0.99 | 0.0 | 0.0 | 12.0* | 8/24 |
| 70 | 5.0 | 45.5 | 49.5 | 0.99 | 3.0 | 3.0 | 0.0 | 8/24 |
| 71 | 5.0 | 45.5 | 49.5 | 0.99 | 3.0 | 0.0 | 3.0 | 8/24 |
| 72 | 5.0 | 45.5 | 49.5 | 0.99 | 0.0 | 3.0 | 3.0 | 8/24 |
| 73 | 5.0 | 45.5 | 49.5 | 0.99 | 4.0 | 4.0 | 3.0 | 8/24 |
| 74* | 5.0 | 45.5 | 49.5 | 0.99 | 4.0* | 4.0* | 4.0* | 8/24 |

Referring to Tables 1 to 3, asterisked numerals denote comparative samples which are out of the inventive ranges. Referring to comparative samples, composition ratios of asterisked components are out of the inventive ranges.

Dielectric constants ($\varepsilon_{33}^T/\varepsilon_0$), electromechanical coupling factors (Kp) of vibration in expansion directions, and mechanical quality factors (Qm) were measured as to the obtained piezoelectric porcelain samples. An impedance measuring device was employed to measure the dielectric constants at a measuring frequency of 1 kHz while measuring the electromechanical coupling factors of the vibration in the expansion directions by a resonance/antiresonance method. Tables 4 to 6 show the results.

Table 4

| Sample No. | Electric Characteristics | | |
|---|---|---|---|
| | $\varepsilon_{33}{}^T/\varepsilon_0$ | Kp (%) | Qm |
| 1* | 320 | 50.6 | 152 |
| 2 | 405 | 53.3 | 144 |
| 3 | 2073 | 65.2 | 131 |
| 4 | 1041 | 53.4 | 172 |
| 5* | 689 | 48.6 | 183 |
| 6* | 996 | 51.7 | 183 |
| 7 | 1523 | 55.4 | 174 |
| 8 | 1786 | 53.2 | 99 |
| 9* | 1359 | 39.6 | 52 |
| 10* | 312 | 48.2 | 437 |
| 11 | 841 | 54.7 | 346 |
| 12 | 1703 | 55.0 | 106 |
| 13* | 1442 | 51.9 | 121 |
| 14* | 249 | 49.5 | 369 |
| 15* | 641 | 47.1 | 426 |
| 16* | 309 | 50.6 | 141 |
| 17* | 577 | 47.6 | 164 |
| 18* | 1391 | 49.5 | 258 |
| 19 | 1681 | 53.5 | 174 |
| 20 | 2073 | 66.7 | 114 |
| 21 | 1658 | 57.7 | 334 |
| 22* | 1546 | 54.5 | 408 |

Table 5

| Sample No. | Electric Characteristics | | |
|---|---|---|---|
| | $\varepsilon_{33}{}^T/\varepsilon_0$ | Kp (%) | Qm |
| 23* | 490 | 52.5 | 130 |
| 24 | 521 | 54.6 | 125 |
| 25 | 1128 | 68.8 | 122 |
| 26 | 2014 | 70.0 | 118 |
| 27 | 1900 | 62.6 | 143 |
| 28 | 1584 | 58.5 | 153 |
| 29 | 1186 | 54.8 | 157 |
| 30* | 852 | 50.3 | 161 |
| 31* | 1154 | 53.3 | 161 |
| 32 | 1671 | 56.7 | 158 |
| 33 | 1802 | 59.4 | 155 |
| 34 | 2061 | 63.8 | 146 |
| 35 | 2196 | 66.5 | 114 |
| 36 | 1933 | 53.8 | 79 |
| 37* | 1517 | 39.6 | 32 |
| 38* | 454 | 49.5 | 426 |
| 39 | 982 | 54.7 | 331 |
| 40 | 2224 | 67.6 | 183 |
| 41 | 2128 | 64.2 | 130 |
| 42 | 2019 | 58.9 | 124 |

Table 5   (continued)

| Sample No. | Electric Characteristics | | |
|---|---|---|---|
| | $\varepsilon_{33}{}^T/\varepsilon_0$ | Kp (%) | Qm |
| 43 | 1703 | 55.0 | 106 |
| 44* | 1598 | 53.5 | 103 |
| 45* | 403 | 51.2 | 355 |
| 46* | 794 | 48.7 | 405 |
| 47* | 451 | 51.9 | 119 |
| 48* | 726 | 49.2 | 151 |
| 49* | 1547 | 51.2 | 246 |
| 50 | 1826 | 54.9 | 155 |
| 51 | 2104 | 59.8 | 104 |
| 52 | 2192 | 63.6 | 107 |
| 53 | 2223 | 66.7 | 114 |
| 54 | 2038 | 62.2 | 209 |
| 55 | 1814 | 58.9 | 318 |
| 56* | 1695 | 54.5 | 392 |

Table 6

| Sample No. | Electric Characteristics | | |
|---|---|---|---|
| | $\varepsilon_{33}{}^T/\varepsilon_0$ | Kp (%) | Qm |
| 57 | 2204 | 63.8 | 145 |
| 58 | 2253 | 58.1 | 154 |
| 59 | 2261 | 57.0 | 155 |
| 60 | 2569 | 55.1 | 151 |
| 61* | 2581 | 53.8 | 153 |
| 62 | 2146 | 66.2 | 112 |
| 63 | 2165 | 57.5 | 149 |
| 64 | 2310 | 54.8 | 152 |
| 65* | 2344 | 53.1 | 153 |
| 66 | 2042 | 65.3 | 101 |
| 67 | 2067 | 56.8 | 139 |
| 68 | 2322 | 54.6 | 143 |
| 69* | 2359 | 52.7 | 145 |
| 70 | 2204 | 57.9 | 153 |
| 71 | 2159 | 57.3 | 147 |
| 72 | 2098 | 57.2 | 123 |
| 73 | 2306 | 54.6 | 150 |
| 74* | 2339 | 52.9 | 155 |

As to the value of a in the general formula, it is understood possible to obtain piezoelectric porcelain having a large electromechanical coupling factor, a small mechanical quality factor and a high dielectric constant in the inventive range, particularly from the test data of the samples Nos. 10 to 13 and 38 to 44.

As to the values of b and c in the general formula, it is understood possible to obtain piezoelectric porcelain having a large electromechanical coupling factor, a small mechanical quality factor and a high dielectric constant in the inventive ranges, particularly from the test data of the samples Nos. 1 to 5, 14 to 17, 23 to 30 and 45 to 48.

As to the value of x in the general formula, it is understood possible to obtain piezoelectric porcelain having a large electromechanical coupling factor, a small mechanical quality factor and a high dielectric constant in the inventive range, particularly from the test data of the samples Nos. 6 to 9 and 31 to 37.

As to the value of y in the general formula, it is understood possible to obtain piezoelectric porcelain having a large electromechanical coupling factor, a small mechanical quality factor and a high dielectric constant in the inventive range, particularly from the test data of the samples Nos. 18 to 22 and 49 to 56.

As to the rate of substitution of the Pb component by Sr, Ba or Ca, it is understood possible to obtain piezoelectric porcelain having a large electromechanical coupling factor, a small mechanical quality factor and a high dielectric constant in the inventive range, particularly from the test data of the samples Nos. 57 to 74.

Although the present invention has been described and illustrated in detail, it is clearly understood that the same is by way of illustration and example only and is not to be taken by way of limitation, the scope of the present invention being limited only by the terms of the appended claims.

## Claims

1. Piezoelectric porcelain, being a lead-containing composite oxide expressed in a general formula $aPb_x(Cr_yNb_{1-y})O_3$-$bPb_xTiO_3$-$cPb_xZrO_3$, with a, b and c being in the following ranges respectively:

$$1.0 \leq a \leq 12.0$$

$$40.5 \leq b \leq 49.0$$

$$39.0 \leq c \leq 58.5$$

where a, b and c are in units of mole % and $a + b + c = 100$, and x and y being in the following ranges respectively:

$$0.95 \leq x \leq 1.01$$

$$2/24 \leq y \leq 11/24$$

2. The piezoelectric porcelain in accordance with claim 1, wherein the value of a is in the range of $2.0 \leq a \leq 10.0$.

3. The piezoelectric porcelain in accordance with claim 1, wherein the value of b is in the range of $43.0 \leq b \leq 48.0$.

4. The piezoelectric porcelain in accordance with claim 1, wherein the value of c is in the range of $47.0 \leq c \leq 52.0$.

5. The piezoelectric porcelain in accordance with claim 1, wherein the value of x is in the range of $0.96 \leq x \leq 1.00$.

6. The piezoelectric porcelain in accordance with claim 1, wherein the value of y is in the range of $5/24 \leq y \leq 10.5/24$.

7. The piezoelectric porcelain in accordance with claim 1, wherein not more than 11 mole % of said Pb component is substituted by at least one element of Sr, Ba and Ca.

8. The piezoelectric porcelain in accordance with claim 1, wherein not more than 5 mole % of said Pb component is substituted by at least one element of Sr, Ba and Ca.

## Patentansprüche

1. Piezoelektrisches Porzellan, das ein Blei enthaltendes Zusammensetzungsoxid ist, welches durch eine allgemeine Formel $aPb_x(Cr_yNb_{1-y})O_3$-$bPb_xTiO_3$-$cPb_xZrO_3$, mit a, b und c, die jeweils in den folgenden Bereichen sind, ausgedrückt wird:

$$1.0 \leq a \leq 12.0$$

$$40.5 \leq b \leq 49.0$$

$$39.0 \leq c \leq 58.5$$

worin a, b und c Mol %-Einheiten sind und a + b + c = 100 ist, und x und y jeweils in den folgenden Bereichen sind:

$$0.95 \leq x \leq 1.01$$

$$2/24 \leq y \leq 11/24.$$

2. Piezoelektrisches Porzellan nach Anspruch 1, worin der Wert von a in dem Bereich von $2.0 \leq a \leq 10.0$ ist.

3. Piezoelektrisches Porzellan nach Anspruch 1, worin der Wert von b in dem Bereich von $43.0 \leq b \leq 48.0$ ist.

4. Piezoelektrisches Porzellan nach Anspruch 1, worin der Wert von c in dem Bereich von $47.0 \leq c \leq 52.0$ ist.

5. Piezoelektrisches Porzellan nach Anspruch 1, worin der Wert von x in dem Bereich von $0.96 \leq x \leq 1.00$ ist.

6. Piezoelektrisches Porzellan nach Anspruch 1, worin der Wert von y in dem Bereich von $5/24 \leq y \leq 10.5/24$ ist.

7. Piezoelektrisches Porzellan nach Anspruch 1, worin nicht mehr als 11 mol % des Pb-Bestandteiles durch mindestens ein Element von Sr, Ba und Ca ersetzt wird.

8. Piezoelektrisches Porzellan nach Anspruch 1, worin nicht mehr als 5 mol % des Pb-Bestandteiles durch mindestens ein Element von Sr, Ba und Ca ersetzt wird.

**Revendications**

1. Porcelaine piézoélectrique étant un oxyde composite contenant du plomb exprimé dans la formule générale $aPb_x(Cr_yNb_{1-y})O_3\text{-}bPb_xTiO_3\text{-}CPb_xZrO_3$, avec a, b et c se situant respectivement dans les plages suivantes :

$$1,0 \leq a \leq 12,0$$

$$40,5 \leq b \leq 49,0$$

$$39,0 \leq c \leq 58,5$$

où a, b et c sont en unités de pourcentage en moles et a + b + c = 100 et x et y se situant respectivement dans les plages suivantes :

$$0,95 \leq x \leq 1,01$$

$$2/24 \leq y \leq 11/24$$

2. Porcelaine piézoélectrique selon la revendication 1, dans laquelle la valeur de a se situe dans la plage de $2,0 \leq a \leq 10,0$.

3. Porcelaine piézoélectrique selon la revendication 1, dans laquelle la valeur de b se situe dans la plage de 43,0 s b s 48,0.

4. Porcelaine piézoélectrique selon la revendication 1, dans laquelle la valeur de c se situe dans la plage de $47,0 \leq c \leq 52,0$.

5. Porcelaine piézoélectrique selon la revendication 1, dans laquelle la valeur de x se situe dans la plage de $0,96 \leq x \leq 1,00$.

6. Porcelaine piézoélectrique selon la revendication 1, dans laquelle la valeur de y se situe dans la plage de $5,24 \leq y \leq 10,5/24$.

7. Porcelaine piézoélectrique selon la revendication 1, dans laquelle pas plus de 11 % en mole du composant Pb est substitué par au moins un élément de Sr, Ba et Ca.

8. Porcelaine piézoélectrique selon la revendication 1, dans laquelle pas plus de 5 % en mole du composant Pb est substitué par au moins un élément de Sr, Ba et Ca.